Europäisches Patentamt

European Patent Office

Office européen des brevets

(11) Veröffentlichungsnummer: **0 270 184**
**A2**

(12) **EUROPÄISCHE PATENTANMELDUNG**

(21) Anmeldenummer: 87202359.3

(22) Anmeldetag: 30.11.87

(51) Int. Cl.4: **H01L 23/52** , H01L 23/56

(30) Priorität: 03.12.86 DE 3641299

(43) Veröffentlichungstag der Anmeldung:
08.06.88 Patentblatt 88/23

(84) Benannte Vertragsstaaten:
DE FR GB NL

(71) Anmelder: **Philips Patentverwaltung GmbH**
**Wendenstrasse 35 Postfach 10 51 49**
**D-2000 Hamburg 1(DE)**

(84) **DE**

(71) Anmelder: **N.V. Philips' Gloeilampenfabrieken**
**Groenewoudseweg 1**
**NL-5621 BA Eindhoven(NL)**

(84) **FR GB NL**

(72) Erfinder: **Kohsiek, Cord**
**Hamburger Weg 10**
**D-2086 Ellerau(DE)**

(74) Vertreter: **David, Günther M. et al**
**Philips Patentverwaltung GmbH**
**Wendenstrasse 35 Postfach 10 51 49**
**D-2000 Hamburg 1(DE)**

(54) **Integrierte Halbleiter-Schaltung mit Mehrlagenverdrahtung.**

(57) Bei integrierten Halbleiter-Schaltungen mit Mehrlagenverdrahtung, bei der die in dem Halbleiter-Körper realisierten Schaltungselemente (2a,2b,2c) durch Leiterbahnen miteinander verbunden sind, die in mindestens zwei übereinanderliegenden, jeweils durch (eine) isolierende Schicht(en) voneinander getrennte, Ebenen verlaufen können zwischen den Schaltungselementen (2b,2c) und den oberhalb von ihnen verlaufenden Leiterbahnen (4a,4b,4c) unerwünschte Kopplungen auftreten.

Diese störenden Kopplungen werden dadurch vermieden, daß Leiterbahnen (3) einer unteren Verdrahtungsebene in Lage und Form so ausgebildet und an ein solches Potential angelegt sind, daß sie eine Abschirmung zwischen unter ihnen liegenden Schaltungselementen (2b,2c) und einer oder mehreren Leiterbahnen (4a,4b,4c) in einer oberen Verdrahtungsebene bilden.

Fig.1

## Integrierte Halbleiter-Schaltung mit Mehrlagenverdrahtung

Integrierte Halbleiter-Schaltung mit Mehrlagenverdrahtung, bei der die in dem Halbleiterkörper realisierten Schaltungselemente durch Leiterbahnen miteinander verbunden sind, die in mindestens zwei übereinanderliegenden, jeweils durch (eine) isolierende Schicht(en) voneinander getrennte, Ebenen verlaufen.

Bei integrierten Schaltungen dieser Art kann sich das Problem ergeben, daß zwischen den in dem Halbleiterkörper realisierten Schaltungselementen und den oberhalb von ihnen verlaufenden Leiterbahnen unerwünschte (kapazitive) Kopplungen auftreten.

Solche unerwünschten Kopplungen können bei einer integrierten Halbleiter-Schaltung der eingangs genannten Art erfindungsgemäß dadurch vermieden werden, daß Leiterbahnen einer unteren Verdrahtungsebene in Lage und Form so ausgebildet und an ein solches Potential angelegt sind, daß sie eine Abschirmung zwischen unter ihnen liegenden Schaltungselementen und einer oder mehreren Leiterbahnen in einer oberen Verdrahtungsebene bilden.

Weitere Ausgestaltungen der Erfindung ergeben sich aus den Unteransprüchen.

Aus Patent Abstracts of Japan 1985, E 378 war es bereits bekannt bei einer integrierten Halbleiter-Schaltung mit Mehrlagenverdrahtung zwischen zwei Verdrahtungsebenen - durch Isolierschichten von diesem getrennt - eine mit Erdpotential verbundene Metallschicht anzubringen, welche die gesamte Oberfläche bedeckt, um so ein Übersprechen zwischen den Leiterbahnen der beiden genannten Verdrahtungsebenen zu verhindern.

Ein Ausführungsbeispiel der Erfindung wird im folgenden anhand der beigefügten Zeichnung näher erläutert. Es zeigen:

Fig. 1 eine Draufsicht auf eine integrierte Halbleiter-Schaltung mit zwei Verdrahtungsebenen und

Fig. 2 ein Schnitt entlang der Linie II-II in Figur 1.

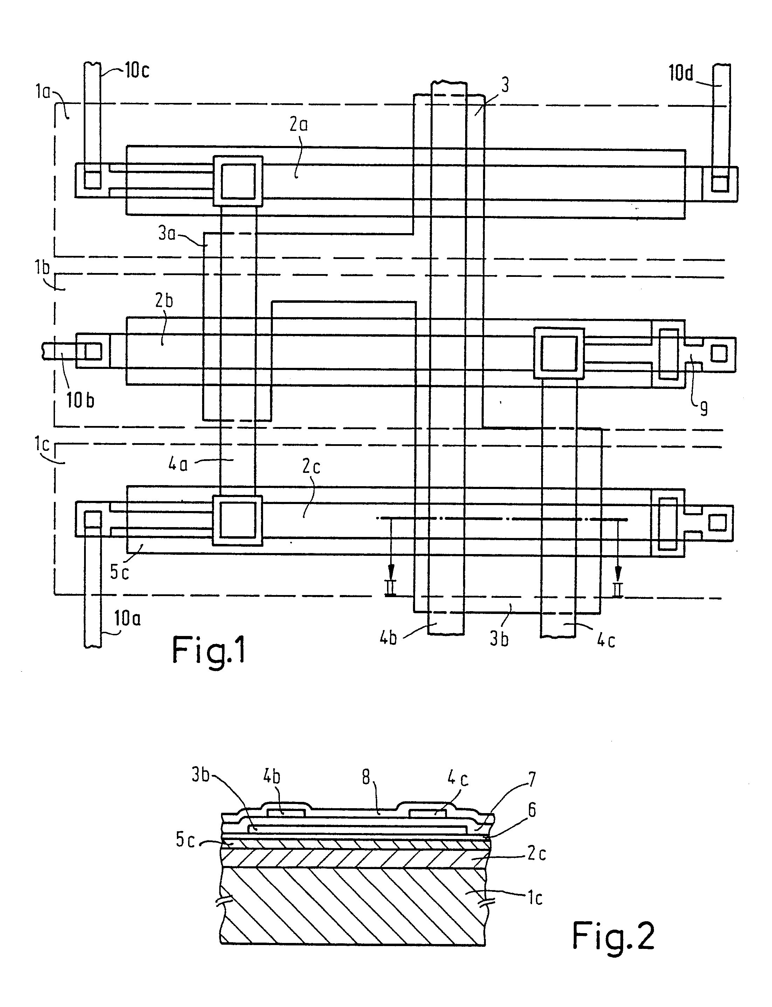

Die Figur 1 zeigt in Draufsicht einen Ausschnitt aus einer integrierten Halbleiter-Schaltung in der in drei Inseln 1a bis 1c drei Widerstände 2a, 2b und 2c realisiert sind. Die Widerstände sind durch in einem N-leitenden Halbleiterkörper vergrabene P-leitende Zonen gebildet. Über diesen Widerständen verlaufen in der oberen Verdrahtungsebene Leitungsbahnen 4a, 4b und 4c die von den Widerständen 2a bis 2c - soweit sie nicht direkt mit ihnen verbunden sind, wie die Leiterbahn 4a mit den Widerständen 2a und 2c, möglichst entkoppelt sein sollen.

Zu diesem Zweck verläuft in der unteren Verdrahtungsebene, neben den sonstigen dort erforderlichen Leiterbahnen, wie z.B. den Leiterbahnen 10a-10d, eine Leiterbahn 3 die sich insbesondere mit ihren Teilen 3a und 3b zwischen den Leiterbahnen 4a bis 4c der oberen Verdrahtungsebene und den Widerständen 2a bis 2c erstreckt. Eine unerwünschte Kopplung kann z.B. auftreten zwischen der oberen Leiterbahn 4c und der oberen Schicht 5c des Halbleiterkörpers, die bei 9 mit dem Widerstand 2b verbunden ist. Diese Leiterbahn 3 ist an geeigneter Stelle mit Masse verbunden und bildet so eine sichere Abschirmung.

Die Figur 2 zeigt dies im Querschnitt für die Kreuzung der Leiterbahnen 4 und 4c der oberen Verdrahtungsebene mit dem Widerstand 2c. Dieser Widerstand 2c ist als eine vergrabene P-leitende Zone 2c in einem N-leitenden Halbleiterkörper 1c und 2c, 5c gebildet auf dem sich - und der hier betrachteten Zone - über einer Isolierschicht 6 der Teil 3b der abschirmenden Leiterbahn 3 erstreckt.

Über dieser verlaufen dann, wieder über einer Nitridschicht 7 die beiden Leiter 4b und 4c der oberen Leiterbahnebene, die nach oben hin wieder von einer Nitridschicht 8 abgedeckt sind.

An der hier betrachteten Stelle ist die als Abschirmung wirkende Leiterbahn der unteren Verdrahtungsebene zu einer Fläche 3b erweitert, die sich unter nebeneinanderliegenden Teilen mehrerer Leiterbahnen, hier 4b und 4c, der oberen Verdrahtungsebene erstreckt.

Durch Verwendung einer solchen, in einer unteren Verdrahtungsebene verlaufenden, beliebig gestalteten und als Abschirmung wirkenden Leiterbahn 3 wird eine gute Entkopplung zwischen den Leiterbahnen der oberen Verdrahtungsebene und den Schaltungselementen erreicht, ohne daß es dazu erforderlich ist, eine besondere nur einer Abschirmung dienenden Metallisierungsebene einzuführen.

### Ansprüche

1. Integrierte Halbleiter-Schaltung mit Mehrlagenverdrahtung, bei der die in dem Halbleiter-Körper realisierten Schaltungselemente (2a, 2b, 2c) durch Leiterbahnen miteinander verbunden sind, die in mindestens zwei übereinanderliegenden, jeweils durch (eine) isolierende Schicht(en) voneinander getrennte, Ebenen verlaufen, dadurch gekennzeichnet, daß Leiterbahnen (3) einer unteren Verdrahtungsebene in Lage und Form so ausgebildet und an ein solches Potential angelegt sind, daß sie eine Abschirmung zwischen unter ihnen liegenden Schaltungselementen (2b,2c) und einer oder mehreren Leiterbahnen (4a,4b,4c) in einer oberen Verdrahtungsebene bilden.

2. Integrierte Halbleiter-Schaltung nach Anspruch 1,

dadurch gekennzeichnet,

daß die eine Abschirmung bildenden Leiterbahnen Flächen (3b) bilden, die sich unter nebeneinanderliegenden Teilen mehrerer Leiterbahnen (4b,4c) einer oberen Verdrahtungsebene erstrecken.

Fig.1

Fig.2

PHD 86-191